# EUROPÄISCHE PATENTSCHRIFT

(11) **EP 1 425 920 B1**
(45) Veröffentlichungstag und Bekanntmachung des Hinweises auf die Patenterteilung: **30.05.2012**
(21) Anmeldenummer: 02776670.8
(22) Anmeldetag: 11.09.2002
(51) Int. Cl.: H04N 7/26, H04N 7/50

(54) **VERFAHREN ZUR VIDEOCODIERUNG UND COMPUTERPROGRAMMPRODUKT**
METHOD OF VIDEO CODING AND COMPUTER PROGRAM PRODUCT
PROCEDE DE CODAGE VIDEO ET PRODUIT-PROGRAMME INFORMATIQUE

(30) Priorität: 14.09.2001 DE 10145373; 25.04.2002 DE 10218541
(43) Veröffentlichungstag der Anmeldung: 09.06.2004
(73) Patentinhaber: SIEMENS AKTIENGESELLSCHAFT, 80333 München (DE)
(72) Erfinder: OERTEL, Norbert, 81669 München (DE); BÄSE, Gero, 81371 München (DE)
(86) Internationale Anmeldenummer: PCT/DE2002/003385
(87) Internationale Veröffentlichungsnummer: WO 2003/026307

(56) Entgegenhaltungen:
- WO-A-03/027940
- US-A- 5 400 075
- US-A- 5 721 822
- MARPE D ET AL: "Adaptive Codes for H.26L" ITU TELECOMMUNICATIONS STANDARDIZATION SECTOR VCEG-M59, XX, XX, 28. März 2001 (2001-03-28), Seiten 1-7, XP002264756
- SIPITCA M ET AL: "Conditional DCT event coding without side information in video compression" IMAGE PROCESSING, 2000. PROCEEDINGS. 2000 INTERNATIONAL CONFERENCE ON, Bd. 1, 10. September 2000 (2000-09-10), Seiten 944-947, XP010530772
- RISSANEN J: "A UNIVERSAL DATA COMPRESSION SYSTEM" IEEE TRANSACTIONS ON INFORMATION THEORY, Bd. IT-29, Nr. 5, 1. September 1983 (1983-09-01), Seiten 656-664, XP000563277
- BÄSE G ET AL: "Enhanced coding of coefficients" ITU TELECOMMUNICATIONS STANDARDIZATION SECTOR VCEG-034R2, 4. Dezember 2001 (2001-12-04), Seiten 1-2, XP002264757
- MARPE D ET AL: "Improved CABAC" ITU TELECOMMUNICATIONS STANDARDIZATION SECTOR VCEG-O18, XX, XX, 4. Dezember 2001 (2001-12-04), Seiten 1-6, XP002257293
- KUCEREN R ET AL: "Improvements on CABAC" ITU TELECOMMUNICATIONS STANDARDIZATION SECTOR VCEG-N41, 24. September 2001 (2001-09-24), Seiten 1-4, XP002264758

## Beschreibung

Die Erfindung betrifft ein Verfahren zur Videocodierung sowie ein Computerprogrammprodukt.

Prädiktive Videocodierverfahren schätzen aus bereits übertragenen Bildbereichen die aktuelle Bildinformation und berechnen einen davon abweichenden Prädiktionsfehler. Die Ermittlung der aktuellen Bildinformation aus dem bereits übertragenen Bildbereichen erfolgt in der Regel dadurch, dass das aktuelle Eingabebild in Blöcke unterteilt wird und zu jedem dieser Blöcke in vorangegangenen Bildern ein korrespondierender Block gesucht wird, der ein Fehler- oder Abstandsmaß minimiert. Das so konstruierte Blockbild wird von dem aktuellen Eingabebild subtrahiert und der so berechnete Prädiktionsfehler wird durch eine diskrete Cosinustransformation oder eine Integertransformation vom Orts- in den Frequenzbereich transformiert. Anschließend werden die transformierten Prädiktionsfehlerdaten quantisiert und die sich daraus ergebenden Koeffizienten mittels kontextadaptiver binärer arithmetischer Codierung (CABAC = Context Adaptive Binary Arithmetic Coder) komprimiert und zum Empfänger gesendet.

Für die arithmetische Codierung werden die in der Prädiktionsfehlermatrix enthaltenen Koeffizienten durch eine Koeffizientenabtastung linearisiert und in einer Folge von Pegeln und Längen von Nullfolgen umgewandelt. Sowohl die Pegelwerte als auch die Längenwerte werden dabei unär dargestellt und unabhängig voneinander Bit für Bit codiert. Die Vorzeichen der Pegel werden getrennt codiert. Zur Codierung der Pegelwerte wird jeweils ein spezifischer Kontext für die ersten beiden Bits benutzt und ein weiterer spezifischer Kontext für alle folgenden Bits. Unter Kontext wird in diesem Zusammenhang die Verteilung der Häufigkeiten der logischen 0 und 1 verstanden. Der Kontext gibt daher die Wahrscheinlichkeit dagesetzt ist. Zur Codierung der Längenwerte wird ein spezifischer Kontext für das erste Bit und ein weiterer spezifischer Kontext für alle folgenden Bits benutzt. Auch für die Codierung des Vorzeichens, welches durch ein einzelnes Bit dargestellt wird, wird ein eigener Kontext verwendet. Die sechs verwendeten spezifischen Kontexte bilden zusammen eine Kontextmenge.

Ein Dokument "MARPE D ET AL: 'Adaptive Codes for H.26L' ITU TELECOMMUNICATIONS STANDARDIZATION SECTOR VCEG-M59, XX, XX, 28. März 2001 (2001-03-28), Seiten 1-7, XP002264756" beschreibt eine Methode die auf einer kontext-adaptiven binären arithmetischen Kodierung beruht.

Ein Dokument "SIPITCA M ET AL: 'Conditional DCT event coding without side information in video compression' IMAGE PROCESS-ING, 2000. PROCEEDINGS. 2000 INTERNATIONAL CONFERENCE ON, Bd. 1, 10. September 2000 (2000-09-10), Seiten 944-947, XP010530772" beschreibt ein DCT Ereigniskodierverfahren, bei dem auf Seiteninformation in einem komprimierten Videostrom verzichtet werden kann.

In einem Dokument Marpe et al., "Improved CABAC", ITU SG16 Q16, VCEG, doc: VECG-O18, Pattaya, Thailand, 4-6.12.2011 werden Möglichkeiten zur Verbesserung einer CABAC-Methode (context-based adaptive binary arithmetic coding) beschrieben.

Ausgehend von diesem Stand der Technik liegt der Erfindung die Aufgabe zugrunde, die kontextadaptive binäre arithmetische Codierung weiter zu verbessern.

Diese Aufgabe wird erfindungsgemäß durch ein Verfahren mit den folgenden Verfahrensschritten gelöst:
- Bereitstellen einer Prädiktionsfehlermatrix;
- Umwandeln der Prädiktionsfehlermatrix durch eine Koeffizientenabtastung in eine Folge von Symbolen;
- Durchführen einer kontextadaptiven arithmetischen Codierung der Symbole auf der Grundlage von Symbolhäufigkeiten, deren Verteilung in Abhängigkeit von einem bereits codierten Symbol ausgewählt wird.

Bei einer bevorzugten Ausführungsform wird die Prädiktionsfehlermatrix durch die Koeffizientenabtastung in einer Folge von Pegeln und Längen von Nullfolgen umgewandelt und die Pegelwerte in Abhängigkeit vom Wert eines zuvor übertragenen Pegels und die Längenwerte in Abhängigkeit vom Wert einer zuvor codierten Länge codiert.

Es sei angemerkt, dass in diesem Zusammenhang unter Pegelwert der Betrag eines Pegels verstanden werden soll. Da die Längen keine negativen Werte annehmen können, werden im folgenden die Längenwerte gelegentlich auch kurz als Längen bezeichnet.

Da die statistischen Abhängigkeiten jeweils zwischen den Pegelwerten und Längenwerten untereinander besonders ausgeprägt sind, ist bei dieser Vorgehensweise eine besonders effiziente Codierung möglich.

Bei einer weiteren bevorzugten Ausführungsform werden die Pegel nach Größe sortiert und so die statistischen Abhängigkeiten zwischen den Pegelwerten verstärkt.

Schließlich ist vorgesehen, die Anzahl der Koeffizienten zu bestimmen und zu codieren. Diese Vorgehensweise erlaubt, die Auswahl der Häufigkeitsverteilung für die Codierung der Symbole auch in Abhängigkeit von der Anzahl der Koeffizienten zu wählen.

Weitere Einzelheiten der Erfindung sind Gegenstand der abhängigen Ansprüche.

Nachfolgend werden Ausführungsbeispiele der Erfindung anhand der beigefügten Zeichnung im Einzelnen erläutert. Es zeigen:
- Figur 1: ein Blockdiagramm eines Encoders;
- Figur 2: ein Blockdiagramm, das die Codierung von Koeffizienten einer Prädiktionsfehlermatrix veranschaulicht;
- Figur 3: ein Diagramm, das den Abtastvorgang der Prädiktionsfehlermatrix zeigt;
- Figur 4: eine globale Häufigkeitsverteilung der Pegelwerte;
- Figur 5: eine Häufigkeitsverteilung von Pegelwerten in Abhängigkeit von einem vorhergehenden Pegelwert;
- Figur 6: eine Darstellung einer zur Codierung der Pegelwerte verwendeten Kontextmenge; und
- Figur 7: eine Darstellung einer zur Codierung der Längen verwendeten Kontextmenge.

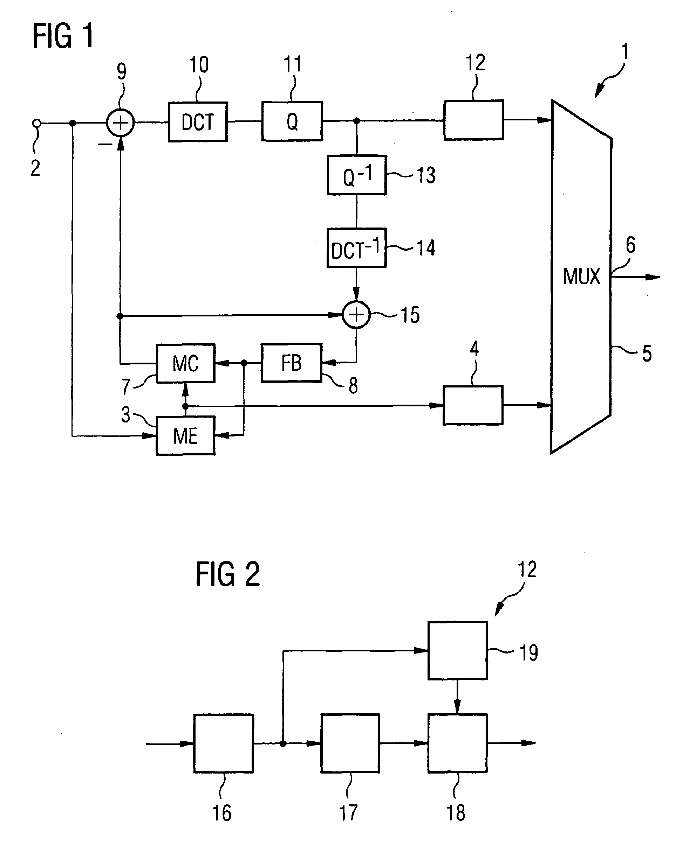

Figur 1 zeigt einen Encoder 1, der nach dem Prinzip der bewegungskompensierenden Hybrid-Codierung arbeitet. Der Encoder 1 verfügt über einen Eingang 2, über den Videodaten dem Encoder 1 zugeführt werden. Eine dem Eingang 2 nachgeordnete Bewegungsschätzeinheit 3 segmentiert ein aktuell zu codierendes Bild des Videodatenstroms in rechteckige Makroblöcke. Für jeden dieser Makroblöcke sucht die Bewegungsschätzeinheit 3 aus den bereits übertragenen Bildern passende Makroblöcke heraus und berechnet deren Bewegungsvektoren. Die Bewegungsvektoren können dann mit Hilfe einer Codiereinheit 4 codiert und über einen Multiplexer 5 in einem an einem Ausgang 6 ausgegebenen Bitstrom eingebettet werden. Die von der Bewegungsschätzeinheit 3 berechneten Bewegungsvektoren der Makroblöcke werden auch einem Bewegungskompensator 7 mitgeteilt, der ausgehend von den in einem Bildspeicher 8 abgespeicherten, bereits übertragenen Bildern das sich durch die Verschiebung der Makroblöcke der bereits übertragenen Bildern ergebende Prädiktionsbild berechnet. Dieses Prädiktionsbild wird in einem Subtrahierer 9 von dem ursprünglichen Bild subtrahiert, um einen Vorhersagefehler zu erzeugen, der einem diskreten Cosinus-Transformator 10 mit nachfolgendem Quantisierer 11 zugeführt wird. Der Vorhersagefehler wird auch als Prädiktionsfehler oder Textur bezeichnet. Der transformierte und quantisierte Vorhersagefehler wird an eine weitere, kontextsensitive Codiereinheit 12 weitergeleitet, die die Prädiktionsfehlermatrix mit Hilfe einer kontextadaptiven, binären arithmetischen Codierung in einen Bitstrom wandelt, der in den Multiplexer 5 eingespeist und in den am Ausgang 6 ausgegebenen Bitstrom eingebettet wird.

Durch die Verarbeitung im diskreten Cosinus-Transformator 10 werden die Makroblöcke mit beispielsweise 8 x 8 Bildpunkte in eine Prädiktionsfehlermatrix mit 8 x 8 Spektralkoeffizienten umgewandelt. Dabei enthält der erste Koeffizient die mittlere Helligkeit des Makroblocks. Der erste Koeffizient wird daher auch als Gleichanteil bezeichnet. Die restlichen Spektralkoeffizienten geben mit steigender Indexzahl höherfrequente Anteile der Helligkeitsverteilung wieder, weshalb sie als Wechselanteile bezeichnet werden.

Durch den nachfolgenden Quantisierer 11 wird die Datenrate weiter verringert. Denn bei flächigen Bildelementen ändert sich der Vorhersagefehler von Bildpunkt zu Bildpunkt nur langsam, so dass nach der Verarbeitung im Quantisierer 11 die meisten hochfrequenten Spektralkoeffizienten gleich Null sind und daher gar nicht erst übertragen werden müssen.

Der Quantisierer 11 berücksichtigt darüber hinaus auch psychovisuelle Effekte. Denn das menschliche Gehirn nimmt niederfrequente Bildkomponenten, nämlich flächenmäßig ausgedehnte Bildkomponenten, wesentlich deutlicher wahr als hochfrequente Bildkomponenten, nämlich Details. Daher werden die hochfrequenten Spektralkoeffizienten gröber quantisiert als die niederfrequenten Spektralkoeffizienten.

Um die im Bildspeicher 8 abgelegten, bereits übertragenen Bilder nachzuführen, werden die Spektralkoeffizienten einem inversen Quantisierer 13 und einem inversen diskreten Cosinus-Transformator 14 zugeführt und die so rekonstruierten Daten des Prädiktionsfehlers auf das von dem Bewegungskompensator 7 erzeugte Prädiktionsbild in einem Addierer 15 aufaddiert. Das so erzeugte Bild entspricht demjenigen Bild, das beim Decodieren entsteht. Dieses Bild wird im Bildspeicher 8 abgelegt und dient der Bewegungsschätzeinheit 3 als Basis für die Berechnung der Bewegungsvektoren der folgenden Bilder.

Die Funktion der kontextsensitiven Codiereinheit 12 wird nachfolgend anhand der Figuren 2 bis 7 beschrieben.

Die in Figur 2 dargestellte kontextsensitive Codiereinheit verfügt über eine Abtastvorrichtung 16, durch die die Spektralkoeffizienten in der transformierten Prädiktionsfehlermatrix in eine Folge von Pegeln und Längen von Nullen umgewandelt werden. Diese Art der Darstellung wird auch als Run/Level-Darstellung bezeichnet. Durch die Abtastvorrichtung 16 wird beispielsweise die Folge von Spektralkoeffizienten 20-1001000000 in die Folge (0/2) (1/-1) (2/1) (0/0) umgewandelt. Dabei gibt die Zahl vor dem Schrägstrich jeweils die Zahl der Nullen vor dem nach dem Schrägstrich angegebenen Pegel an. Die Zahlen vor dem Schrägstrich werden als Längen bezeichnet. Die im letzten Zahlenpaar hinter dem Schrägstrich angegebene Null kennzeichnet den Umstand, dass der Rest der Ziffernfolge aus lauter Nullen besteht. Das letzte Ziffernpaar kann daher auch als Angabe betrachtet werden, die das Ende der Blockübertragung kennzeichnet (EOB = End of Block).

Die von der Abtastvorrichtung 16 erzeugte Folge von Pegeln und Längen wird einem Wandler 17 zugeführt, der die binäre Darstellung in eine unäre (einwertige) Darstellung umwandelt. Dabei werden die im Beispiel angeführten Zahlenpaare jeweils in der Reihenfolge Pegel, Länge der Nullfolge und Vorzeichen des Pegels codiert. Das Zahlenpaar (0/2) wird im vorliegenden Fall also in die unäre Folge 110/0/0 und das Zahlenpaar (1/-1) in die Folge 10/10/1 umgewandelt.

Die unäre Ziffernfolge wird abschließend einem arithmetischen Codierer 18 zugeführt, der die eigentliche kontextadaptive arithmetische Codierung durchführt. Für die Durchführung der kontextadaptiven arithmetischen Codierung benötigt der arithmetische Codierer 18 jeweils die Häufigkeit, mit der die Einsen und Nullen in dem vom Wandler 17 gelieferten unären Datenstrom auftreten. Diese Wahrscheinlichkeiten und damit die Verteilung der Häufigkeiten der Einsen und Nullen werden dem arithmetischen Codierer 18 von einem Analysator 19 geliefert, der von der Abtastvorrichtung 16 mit der Folge von Pegeln und Längen beaufschlagt wird und daraus aktuelle Verteilungen der Wahrscheinlichkeit für das Auftreten von logischen Nullen und Einsen bestimmt.

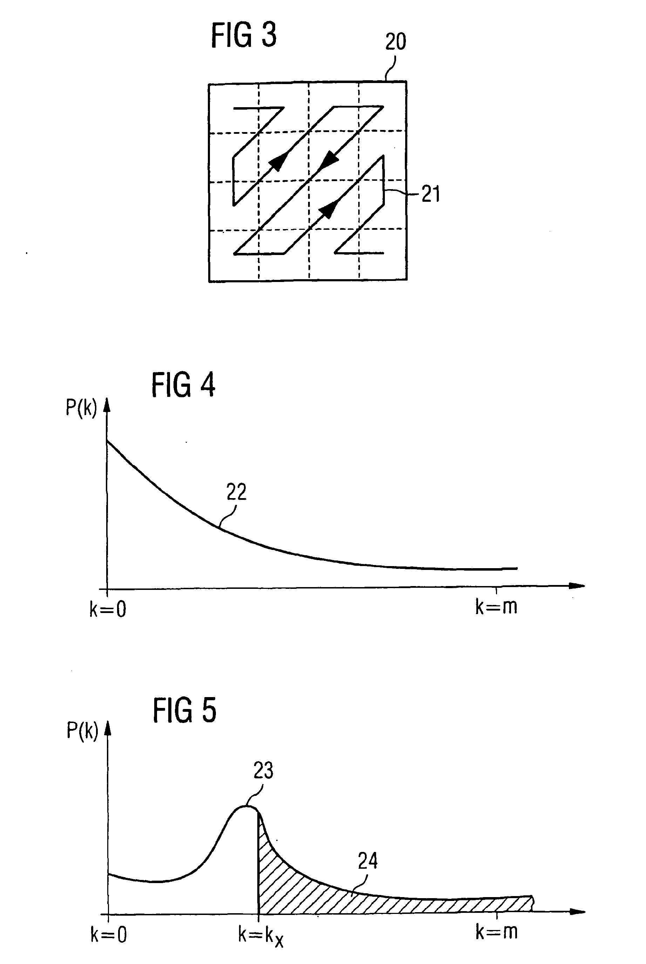

In der hier beschriebenen Codiereinheit 12 werden auf besondere Weise statistische Abhängigkeiten zwischen den Pegeln und Längen berücksichtigt. Diese statistischen Abhängigkeiten beruhen auf dem Umstand, dass große Pegelwerte meist zu Beginn des Abtastvorgangs auftreten. Umgekehrt sind große Längenwerte gegen Ende des Abtastvorgangs zu häufiger. Denn gemäß Figur 3 wird die transformierte Prädiktionsfehlermatrix 20 mit einem Zick-Zack-Muster 21 abgetastet, durch das zunächst die niederfrequenten Spektralkoeffizienten und dann die höherfrequenten Spektralkoeffizienten ausgelesen werden. Große Pegelwerte treten daher vor allem zu Beginn des Abtastvorgangs, also zu Beginn der Folge von Pegeln und Längen auf.

In Figur 4 ist ein Diagramm dargestellt, in dem eine Verteilungskurve 22 die Häufigkeitsverteilung P(k) in Abhängigkeit von den Pegelwerten k angibt. Allgemein gilt, dass die Wahrscheinlichkeit für kleine Pegelwerte größer ist als für große Pegelwerte. Die Verteilungskurve 22 fällt daher ausgehend von einem Maximalwert bei dem Pegelwert k = 0 monoton ab.

Figur 5 enthält ein weiteres Diagramm, in das eine Verteilungskurve 23 eingezeichnet ist, die die Häufigkeitsverteilung P(k|k = kₓ) für die Wahrscheinlichkeit dafür angibt, dass nach einem Pegelwert k = kₓ der Pegelwert k auftritt. Diese Verteilungskurve 23 weist ein Maximum auf, das bei einem Wert k < kₓ liegt. Das bedeutet, dass nach dem Auftreten eines Pegelwerts k = kₓ kleinere Pegelwerte sehr wahrscheinlich sind. Dies entspricht der Tatsache, dass die Pegelwerte gegen Ende des Abtastvorgangs hin abnehmen.

Aufgrund der statistischen Abhängigkeit der Pegelwerte untereinander ist es sinnvoll, die Häufigkeiten für die Nullen und Einsen, die der kontextadaptiven arithmetischen Codierung im arithmetischen Codierer 18 zugrundeliegen, auch in Abhängigkeit vom Wert des zuvor codierten Pegels auszuwählen.

Die statistischen Abhängigkeiten können noch verstärkt werden, wenn die Pegelwerte der Größe nach sortiert werden. Geeignete Sortierverfahren, bei dem die Pegelwerte der Größe nach sortiert werden und bei denen die Sortierinformation separat übertragen wird, sind dem Fachmann bekannt und als solche nicht Gegenstand der Erfindung. Daneben kommen auch zukünftige Sortierverfahren für die Anwendung in diesem Zusammenhang in Frage.

Durch die Sortierung der Pegel wird ein in Figur 5 schraffiert eingezeichneter Kurventeil 24 gewissermaßen abgeschnitten. Dadurch wird die statistische Abhängigkeit der Pegelwerte weiter verstärkt.

Die statistischen Abhängigkeiten betreffen nicht nur die Pegelwerte, sondern auch die Längen. Wie bereits erwähnt, treten große Längenwerte, insbesondere gegen Ende des Abtastvorgangs hin, auf. Es ist daher auch sinnvoll, die Verteilung der Häufigkeiten für die Nullen und Einsen, die der arithmetischen Codierung in dem arithmetischen Codierer 18 zugrundeliegt, in Abhängigkeit vom Wert der zuvor codierten Längen auszuwählen.

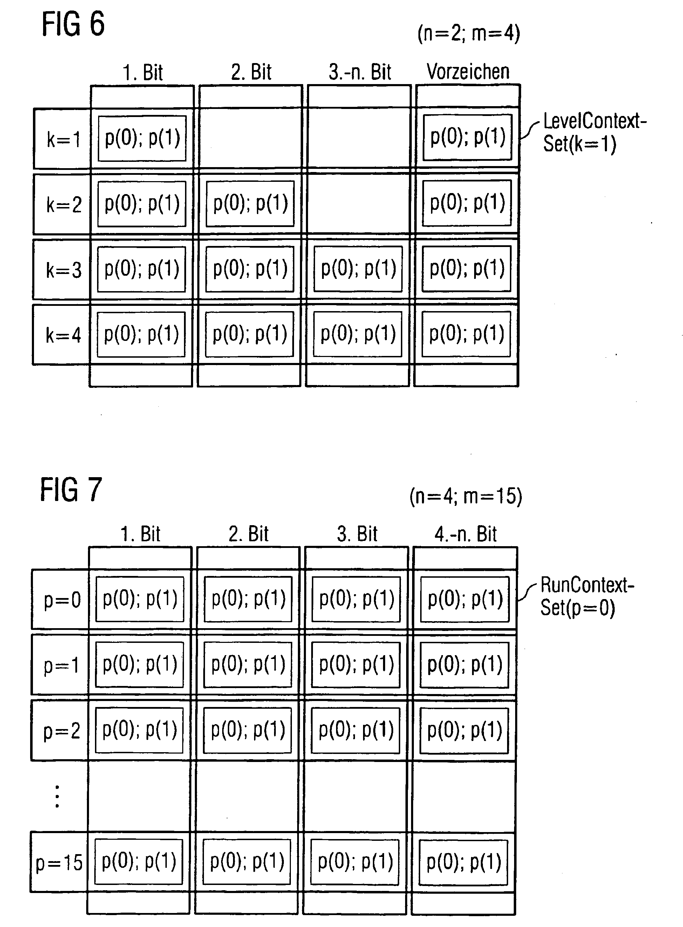

In den Figuren 6 und 7 sind die Kontextmengen, die für die Codierung der Pegelwerte und Längenwerte verwendet werden, graphisch dargestellt.

In Figur 6 sind insbesondere die Kontextmengen dargestellt, die der Codierung der sortierten Pegelwerte zugrundeliegen. Im vorliegenden Fall wurde für die Zahl der individuell codierten Bitstellen n = 2 und für die Zahl der individuell codierten Pegelwerte m = 4 gewählt. Wie bereits erwähnt, wird die Codierung eines Pegelwerts 1 abhängig vom Betrag des zuvor codierten Pegels k durchgeführt.

Es sei angemerkt, dass bei der unären Darstellung von sortierten Pegelwerten die für die unäre Darstellung von 1 verwendete abschließende Null entfallen kann, wenn 1 == k gilt, da der maximale Wert für 1 gleich k ist.

Für die ersten min(n, k) Bit wird jeweils ein eigener Kontext verwendet. Für alle möglichen folgenden Bits bis zur maximalen Länge der unären Darstellung von 1 wird ein Sammelkontext verwendet. In Figur 5 ist dies der Sammelkontext für das dritte und die folgenden Bits. Im Versuch hat sich 2 als günstiger Wert für n erwiesen. Das Vorzeichen wird mit einem einzelnen Bit dargestellt und es wird ein spezifischer Vorzeichenkontext zur Codierung des Vorzeichens verwendet. Die Kontextmenge zur Codierung eines Pegels mit Betrag 1 unter der Voraussetzung, dass der zuletzt codierte Pegel den Betrag k hat, umfasst also min(k+1, min(n,k)+2) Kontexte und wird im Folgenden mit LevelContextSet(k) bezeichnet.

Bei der Codierung des ersten aus der transformierten Prädiktionsfehlermatrix ausgelesenen Pegels kann nicht auf einen zuvor codierten Pegel zurückgegriffen werden, so dass der erste ausgelesene Pegelwert separat codiert werden muss. Als Kontext für den ersten zu codierenden Pegelwert wird der Kontext des größtmöglichen Pegelwerts angenommen, der bedingt durch die Transformation und die nachfolgende Quantisierung möglich ist.

Im übrigen kann anstelle der verschiedenen Kontexte für ein k > m der Kontext für k = m als Sammelkontext verwendet werden. Für die Codierung eines Pegelwerts 1 abhängig vom vorhergehenden Pegelwert k wird daher gemäß Figur 6 folgende Kontextmenge verwendet: LevelContextSet(min(m,k)). Im Versuch hat sich m = 4 als günstiger Wert erwiesen.

Grundsätzlich besteht allerdings auch die Möglichkeit, die Parameter n und m dynamisch zu gestalten und die dafür gewählten Werte in einen Header zu übertragen.

Die Codierung einer Länge r wird abhängig von der zuvor codierten Länge p durchgeführt. Für die erste Länge gilt: p = 0. Wie für die Pegelwerte wird auch für die ersten n Bits jeweils ein eigener Kontext verwendet. Für alle folgenden Bits wird ein gemeinsamer Kontext benutzt. Im Versuch hat sich n = 3 bewährt. Die Kontextmenge zur Codierung einer Länge r unter der Voraussetzung, dass die zuletzt codierte Länge den Betrag p hat, wird im Folgenden mit RunContextSet(p) bezeichnet. Für die Codierung einer Länge r abhängig von p wird folgende Kontextmenge verwendet: RunContextSet(min(m,p)). Im Versuch erwies sich m = 5 als günstiger Wert.

Grundsätzlich besteht ebenfalls die Möglichkeit, den Parameter m in diesem Zusammenhang dynamisch zu gestalten und den dafür ausgewählten Wert mit Hilfe eines geeigneten Informationselements zu übertragen.

Durch das hier beschriebene Verfahren, bei dem die zur Codierung verwendeten Kontexte in Abhängigkeit vom zuvor codierten Pegelwert oder Längenwert ausgewählt werden, kann die Datenrate um 2 bis 3 % reduziert werden.

Eine weitere Reduzierung kann erzielt werden, wenn das Ende der aus der Prädiktionsfehlermatrix ausgelesenen Folge von Pegeln und Längen nicht über den Pegelwert 0 codiert wird, sondern wenn der Folge die Anzahl der von 0 verschiedenen ausgelesenen Pegeln vorangestellt wird. Im oben angeführten Beispiel ergäbe sich dann nicht die Folge (0/2)(1/-1)(2/1) (0/0), sondern 3(0,2)(1/-1)(2/1).

In diesem Fall kann die Information über die Anzahl der von 0 verschiedenen Pegelwerten für eine effiziente Codierung der Pegelwerte benutzt werden. Denn transformierte Prädiktionsfehlermatrizen mit wenigen von 0 verschiedenen Spektralkoeffizienten haben in der Regel nur Spektralkoeffizienten mit sehr kleinen Pegelwerten. Es ist daher sinnvoll, in Abhängigkeit von der Anzahl der von 0 verschiedenen Spektralkoeffizienten nun zwischen verschiedenen Kontextmengen umzuschalten und damit die Effizienz des Codiervorgangs zu steigern.

Alternativ ist es auch möglich, in Abhängigkeit vom Betrag des ersten übertragenen Pegelwerts zwischen verschiedenen Kontextmengen umzuschalten.

Die Berücksichtigung der Anzahl der von 0 verschiedenen Koeffizienten bei der Codierung durch entsprechend angepasste Kontextmengen reduziert die Datenrate des am Ausgang 6 ausgegebenen Bitstroms um weitere 5 bis 6 %.

Die hier beschriebenen Vorrichtungen und Verfahren eignen sich zur Anwendung im Rahmen existierender Videostandards wie H.263 und MPEG-4 sowie H.26L. Die hier beschriebenen Verfahren und Vorrichtungen sind jedoch auch für die Anwendung von zukünftigen, den heutigen Standards entsprechenden Standards geeignet.

Das hier beschriebene Verfahren und die hier beschriebenen Vorrichtungen sind besonders bei niedrigen Datenraten effizient, da sehr viele Pegel bei niedrigen Datenraten betragsmäßig den Wert 1 aufweisen. Dies ließ sich jedoch bisher nicht effizient statistisch modellieren, da der Schluss vom zuletzt codierten Pegelwert auf den Wertebereich des aktuell zu codierenden Pegelwerts ohne ein Vorwissen über die Folge der Koeffizienten nicht möglich ist.

Abschließend sei darauf hingewiesen, dass die hier beschriebenen Vorrichtungen und Verfahren sowohl in Hardware- als auch in Software realisiert werden können.

## Patentansprüche

1. Verfahren zur Videocodierung mit den Verfahrensschritten:
- Bereitstellen einer Prädiktionsfehlermatrix;
- die Prädiktionsfehlermatrix durch eine Koeffizientenabtastung in eine Folge von Pegeln und Längen von Nullfolgen umgewandelt wird;
- die Pegel jeweils kontextadaptiv arithmetisch codiert werden, wobei die Verteilung der zugrundegelegten Pegelwerthäufigkeiten in Abhängigkeit vom jeweils zuvor codierten Pegelwert ausgewählt wird.
- die Anzahl der bei der Koeffizientenabtastung von 0 verschiedenen ausgelesenen Pegel codiert und übertragen wird; und **gekennzeichnet dadurch daß**
- die Auswahl der Verteilung der Pegelwerthäufigkeiten in Abhängigkeit von der Anzahl der von 0 verschiedenen ausgelesenen Pegel durchgeführt wird.

2. Verfahren nach Anspruch 1,
bei dem die Pegel und Längen unär repräsentiert werden.

3. Verfahren nach einem der Ansprüche 1 bis 2,
bei dem die Längen kontextadaptiv arithmetisch codiert werden, wobei die zugrundegelegte Verteilung der Längenwerthäufigkeiten in Abhängigkeit vom zuvor codierten Längenwert ausgewählt wird.

4. Verfahren nach einem der Ansprüche 1 bis 36,
bei dem die Pegelwerte vor der kontextadaptiven arithmetischen Codierung nach Pegelwerten sortiert werden.

5. Computerprogrammprodukt, das Programmcodes zur Ausführung eines Verfahrens nach einem der Ansprüche 1 bis 4 enthält.

## Claims

1. Method for video coding with the following method steps:
- Provision of a prediction error matrix;
- The prediction error matrix is converted by coefficient sampling into a series of levels and lengths of zero sequences;
- The levels are arithmetically encoded context-adaptively in each case, with the distribution of the underlying level value frequencies being selected depending on an already encoded level value;
- The number of levels differing from 0 read out during the coefficient sampling is encoded and transmitted;
And **characterised in that**
- The distribution of the symbol frequencies is selected as a function of the number of levels read out different from 0.

2. Method in accordance with claim 1,
in which the levels and lengths are represented as unary values.

3. Method in accordance with one of claims 1 to 2,
in which the lengths are arithmetically encoded context-adaptively in each case, with the distribution of the underlying length value frequencies being selected depending on the length value encoded beforehand in each case.

4. Method in accordance with one of claims 1 to 3,
in which the level values are sorted before the context-adaptive arithmetic encoding in accordance with level values.

5. Computer program product which contains program code to execute a method in accordance with one of claims 1 to 4.

## Revendications

1. Procédé de codage vidéo comportant les étapes suivantes .
- une matrice d'erreurs de prédiction est mise à disposition ;
- la matrice d'erreurs de prédiction est convertie en une suite de niveaux et de longueurs de suites de zéros par un balayage de coefficients ;
- les niveaux sont respectivement soumis à un codage arithmétique adaptatif selon le contexte, la distribution des fréquences des valeurs de niveaux prises comme base étant sélectionnée en fonction de la valeur de niveau respectivement codée au préalable ;
- le nombre des niveaux différents de 0 lus lors du balayage de coefficients est codé et transmis ;
et **caractérisé en ce que** :
- la sélection de la distribution des fréquences des valeurs de niveaux est opérée en fonction du nombre de niveaux lus qui sont différents de 0.

2. Procédé selon la revendication 1, dans lequel les niveaux et les longueurs sont représentés sous forme unaire.

3. Procédé selon l'une des revendications 1 à 2, dans lequel les longueurs sont soumises à un codage arithmétique adaptatif selon le contexte, la distribution, prise comme base, des fréquences des valeurs de longueurs étant sélectionnée en fonction de la valeur de longueur préalablement codée.

4. Procédé selon l'une des revendications 1 à 3, dans lequel les valeurs de niveaux sont triées selon des valeurs de niveaux avant le codage arithmétique adaptatif selon le contexte.

5. Produit de programme informatique qui contient des codes de programmes pour exécuter un procédé selon l'une des revendications 1 à 4.
